# EUROPEAN PATENT APPLICATION

(11) **EP 1 702 963 A1**
(43) Date of publication of application: **20.09.2006**
(21) Application number: 06250295.0
(22) Date of filing: 20.01.2006
(51) Int. Cl.: C09D 171/00, C09D 171/02, C08G 65/336, C08K 9/06, H01L 21/768, C23C 14/06

(54) **Anti-moisture and soil-repellent coatings**

(30) Priority: 14.03.2005 US 79722
(71) Applicant: JDS Uniphase Corporation, San Jose, CA 95131 (US)
(72) Inventor: Zieba, Jerry, Santa Rosa California 95405 (US); Mayer, Thomas, Santa Rosa California 95404 (US); Aldridge, Heather, Santa Rosa California 95404 (US); Van Milligen, Fred, Santa Rosa California 95403 (US); Beams, Donald Anthony, Santa Rosa California 95401 (US); Duffy, Brad A., Santa Rosa California 95403 (US)
(74) Representative: McKechnie, Neil Henry

(57) **Abstract**

An anti-moisture and soil-repellent coating and a method of preparing the same includes a fluorinated alkyl ether polymer having a functionalized silane that is applied to a non-oxide surface. Advantageously, the instant invention provides a durable anti-moisture and soil-repellant coating for relatively inert surfaces, such as MgF₂, without the need for a primer layer.

## Description

### CROSS-REFERENCE TO RELATED APPLICATIONS

Not Applicable.

### MICROFICHE APPENDIX

Not Applicable.

### TECHNICAL FIELD

The present application relates generally to anti-moisture and soil-repellent coatings, and more particularly, to a durable anti-moisture and soil-repellent coating formed from a fluorinated silane and applied directly to a non-SiO₂ surface.

### BACKGROUND OF THE INVENTION

Anti-moisture and soil-repellent coatings are widely used in industry for protecting surfaces. In many applications, these coatings are fabricated from a compound that includes a hydrolysable group, such as a silane or silane derivative, and a long chain fluorinated hydrocarbon group. Such fluorinated silanes are known for their ability to self-assemble into monolayers with the silane group adjacent to the surface and the long chain fluorinated hydrocarbon group extending from the surface. The resulting coating has an extremely low surface energy, and thus exhibits both hydrophobic (anti-moisture) and oleophobic (soil-repellent) properties. Moreover, the low surface energy provides increased surface lubrication, which advantageously increases the scratch resistance of the surface.

One particularly important application of anti-moisture and soil-repellent coatings is protecting optical components, such as anti-reflection coatings. In order to minimize reflections, antireflection coatings are typically fabricated with an outer layer that has a relatively low index of refraction, such as silicon dioxide (SiO₂) or magnesium fluoride (MgF₂). Unfortunately, these low refractive index materials often exhibit a high surface energy, as shown by a low contact angel with water, and are the reason that most antireflection coatings are highly susceptible to contamination from dirt, oil, and fingerprints. Providing an anti-moisture and soil-repellent protective layer helps to protect these antireflection coatings.

Conveniently, anti-moisture and soil-resistant coatings formed from fluorinated silanes and deposited on SiO₂ surfaces have been found to be reasonably durable (e.g., exhibit good resistance to wiping and scratching). The strong adhesion is believed to occur due to a large number of hydroxyl (-OH) groups available at the SiO₂ surface for chemically bonding to silane and/or its derivatives. In contrast, anti-moisture and soil-resistant coatings formed from fluorinated silanes and deposited on MgF₂ surfaces have been associated with poor durability.

One approach to improving the durability of anti-moisture and soil-resistant coatings applied to MgF₂ and other relatively inert surfaces, has been to use a primer layer. The primer layer, which is typically formed from SiO₂, is deposited on the surface before the fluorinated silane (e.g., as discussed in US Pat. Nos. 6,143,358 and 6,472,073, hereby incorporated by reference). Unfortunately, providing a primer layer increases the complexity of the manufacturing process, and thus increases costs.

It is an object of the instant invention to provide a durable anti-moisture and soil-repellent coating formed from a fluorinated silane and that is applied directly to a non-SiO₂ surface.

### SUMMARY OF THE INVENTION

In accordance with one aspect of the instant invention there is provided a method of providing an anti-moisture and soil-repellent coating comprising: applying a fluorinated alkyl ether polymer having a functionalized silane to a non-oxide surface, said fluorinated alkyl ether polymer applied to the surface in the absence of a primer.

In accordance with another aspect of the instant invention there is provided an anti-moisture and soil-repellent coating comprising: a first layer comprising a non-oxide material; and a second layer of material formed directly on the first layer, the second layer comprising a fluorinated alkyl ether polymer having a functionalized silane, wherein the second layer is coupled to the first layer so as to form a durable coating.

In accordance with one aspect of the instant invention there is provided a method of providing an anti-moisture and soil-repellent coating comprising: applying a fluorinated alkyl ether silane to a substrate that does not contain substantial amounts of an oxide on its surface, said fluorinated alkyl ether silane applied directly to the substrate in the absence of a primer so as to form a durable anti-moisture and soil-repellent coating that exhibits resistance to wiping and scratching.

In accordance with one aspect of the instant invention there is provided a method of providing an anti-moisture and soil-repellent coating comprising: applying a fluorinated alkyl ether polymer having a functionalized silane to a substrate in the absence of a primer to form a durable anti-moisture and soil-repellent coating, said substrate formed of a compound selected from the group consisting of metal halide, metal sulfide, metal selenide, metal telluride, inorganic nitride, semiconductor, aluminate, phosphate, borate, niobate, arsenate, titanate, and carbonate.

### DETAILED DESCRIPTION

The instant invention provides a durable anti-moisture and soil-repellent coating that is compatible with a variety of non-SiO₂ surfaces. In particular, it is recognized that various fluorinated silanes are applicable to surfaces that do not contain substantial amounts of SiO₂, and yet still provide a durable coating.

According to a preferred embodiment of the instant invention, the anti-moisture and soil-repellent coating includes a fluorinated alkyl ether polymer with a chemically reactive silane.

One example of such a compound has the general formula

**R**_{**m**}**-Si-X**_{**n**} (1)

where R includes the fluorinated alkyl ether repeat unit, X is an alkoxy group, a chloride, or an amine group, and m+n equals 4. For example, poly(perfluoropropyl ether) functionalized with a trimethoxy silane group and poly(perfluoroethyl ether) functionalized with a silazane group, are two such compounds.

An anti-moisture and soil-repellent coating that is particularly durable includes a compound having the simplified formula

**CF**_{**3**}**-[CH(CF**_{**3**}**)-CH**_{**2**}**-O-]**_{**x**}**-CONCH**_{**3**}**-(CH**_{**2**}**)**_{**3**}**-Si-(OC**_{**2**}**H**_{**5**}**)**_{**3**} (2)

where x = 7-11. Notably, this compound also includes a divalent linking group (i.e., -CONCH₃₋(CH₂)₃-)- Of course, compounds similar in structure and function to that shown in formula (2) are also within the scope of the instant invention. In particular, both N-methyl-N-(-triethoxypropyl)-2-[α-heptafluoropropoxy{Poly(oxy(trifluoromethyl)-1,2-ethanediyl)} tetrafluoropropionamide, available from SynQuest Laboratories Inc., and Optool DSX^{™}, available from Daikin, have been shown to provide particularly durable coatings.

Methods of applying the anti-moisture and soil-repellent coating include wet techniques such as dipping, flowing, wiping, and/or spraying the surface with a liquid, solution, or gel-like carrier containing the coating compound, and dry techniques such as vapour coating the coating compound onto the surface (either at ambient pressure or under vacuum).

According to a preferred embodiment of the instant invention, the anti-moisture and soil-repellant coating is applied directly to a surface that does not contain substantial amounts of SiO₂ and/or other oxides (i.e., binary compounds formed between elements and oxygen).

Some examples of suitable surface materials include metal halides such as MgF₂, YF₃, LiF, CaF₂, and LiYF₄, metal sulfides such as ZnS, CdS, ZnCr₂S₄, and PbS, metal selenides such as ZnSe, metal tellurides such as ZnTe, inorganic nitrides such as Si₃N₄, carbon boride (CB), and semiconductor materials such as GaAs, GaP, InP, and InSb. Other suitable surface materials include salts having oxygen in their anions. For example, aluminates (e.g., YAlO₃), phosphates (e.g., NH₄H₂PO₄ and KTiOPO₄), borates (e.g., LiB₃O₄ and CsB₂O₃), niobates (e.g., LiNbO₃), arsenates (e.g., KTiOAsO₄), titanates (e.g., BaTiO₃), and carbonates (e.g., CaCO₃) are all suitable materials.

Notably, the above-mentioned suitable materials are not generally viewed as providing a large number of surface hydroxyl (-OH) groups, especially when compared to SiO₂ and/or metal oxides such as TiO₂, Al₂O₃, and ZrO₂. Since surface hydroxyl groups are believed to improve the adhesion of silane-based anti-moisture and soil-repellent coatings, it is not obvious that these non-oxide surfaces would be able serve as a base for a durable silane-based anti-moisture and soil-repellent coating. In particular, it is not obvious that surface materials that do not contain stoichiometric amounts of oxygen, such as MgF₂, Si₃N₄, and YF₃, would be able to provide a sufficient number of hydroxyl groups to support the formation of a durable anti-moisture and soil-repellent coating. The instant inventors, however, have recognized that fluorinated alkyl ether polymers do in fact provide durable anti-moisture and soil-repellent coatings on surfaces formed from these relatively inert non-oxide materials.

The durability of anti-moisture and soil-resistant coatings in accordance with various embodiments of the instant invention have been tested via both mechanical and chemical experiments. For example, chemical resistance was tested against a number of chemical agents including various commercial solvents, bases and acids, while mechanical durability was evaluated by subjecting the coatings to a steel wool rubbing test. The cleanability of the coatings was evaluated by the ease and completeness of removal of stains left by fingerprints and/or a permanent Sharpie^{™} pen.

Positive results from the various rubbing and solvent experiments support the belief that chemical bonds exist between the non-primed surface and the fluorinated silane molecules. For example, for MgF₂ and Si₃N₄ it is suspected that the presence of MgₓO_{y}F_{z} and SiₓO_{y}N_{z}. compounds, respectively, supports the formation of stable hydroxyl groups. The hydroxyl groups offer reactive sites for the condensation reaction with the Si-(O-Alkyl)₃, Si-Cl₃ and/or Si-(NH₂)₃ groups.

The strong adherence between the anti-moisture and soil-repellent coatings and the relatively inert surfaces is believed to arise from the porous nature of the latter. For example, when materials such as MgF₂ and Si₃N₄ are deposited on a substrate using a vacuum deposition process, a porous film is created. The level and extent of the porosity varies with the deposition conditions and the material that is deposited. When fluorinated silanes diffuse into these pores, they react with water that has been adsorbed and/or chemisorbed into the pores from the vacuum chamber. The diffused fluorinated silane molecules then become physically trapped through cross-linking and hydrogen bonding, and thus firmly anchor the anti-moisture and soil-repellent coating.

### EXAMPLES

The following examples further illustrate embodiments of the instant invention, however, the instant invention is not limited by said Examples.

### Example 1

A sample of antireflective coating having MgF₂ as low refractive index material on its outer layer was exposed for 10 minutes at 200°C to vapors of the compound presented in formula 2. At the end of this time, the antireflection coating was removed from the vapor atmosphere and cooled down to room temperature.

The contact angle with water measured 116-117°C. Mechanical and chemical durability tests indicated that a stable bond between the fluorinated silane molecules and the MgF₂ layer of the antireflection coating was achieved. Notably, the Sharpie^{™} pen and fingerprint cleanability tests also delivered positive results.

### Example 2

In this test we exposed samples of the same type as in Example 1 to vapors of Optool DSX^{™}. At the end of this time, the antireflection coating was removed from the vapor atmosphere and cooled down to room temperature.

The contact angle with water measured 116-117°C. Durability and soil cleanability evaluation tests provided positive results.

### Example 3

A sample of heat rejection coating containing a SiₓN_{y} topcoat layer was exposed for 10 minutes at 200°C to vapors of the compound presented in formula 2. After this period of time the sample was removed from the vapor atmosphere and cooled down to room temperature.

The contact angle with water measured 110-117°C. Mechanical and chemical durability tests indicated that a stable bond between fluorinated silane molecules and the SiₓN_{y} layer of antireflection coating was formed. Sharpie^{™} pen and fingerprint cleanability tests delivered positive results.

### Example 4

A process of depositing silver mirror over-coated with yttrium fluoride (YF₃) was modified by including a step of depositing Optool DSX^{™} onto the YF₃ layer without breaking the vacuum. The deposition was performed using a resistively heated source.

The quality of the anti-moisture and soil-repellent treatment was evaluated by measuring the contact angle with water on a pristine coating and a coating rubbed with acetone saturated cotton cloth. A high value of the contact angle ranging between 118 and 123 degrees did not show significant deterioration after the acetone treatment. This supports the belief that a bond has been established between the YF₃ surface and the fluorinated silane molecules.

As shown in the above examples, the instant invention provides a durable anti-moisture and soil-repellant coating for non-oxide materials ― without using a primer and/or without needing to activate the surface. By way of a non-limiting example, the coatings were shown to be sufficiently durable to maintain a constant contact angle after 100 rubs with steel wool and/or with a rinse with various solvents. Advantageously, the absence of a primer layer simplifies the manufacturing process, and thus reduces manufacturing costs. The anti-moisture and soil-repellent coating provides a moisture barrier and protects against environmental factors.

Notably, these anti-moisture and soil-repellent coatings are particularly useful for protecting MgF₂ anti-reflection surfaces, where they also protect against delamination and provide an antifogging treatment. Advantageously, these anti-moisture and soil-repellent coatings do not significantly change the optical properties of the antireflection coating. Of course, the anti-moisture and soil-repellent coatings are also suitable for other optical components, such as MgF₂ lenses.

The embodiments of the invention described above are intended to be exemplary only. The scope of the invention is therefore intended to be limited solely by the scope of the appended claims.

## Claims

1. A method of providing an anti-moisture and soil-repellent coating comprising:
applying a fluorinated alkyl ether polymer having a functionalized silane to a non-oxide surface, said fluorinated alkyl ether polymer applied to the surface in the absence of a primer.

2. A method according to claim 1, wherein the fluorinated alkyl ether polymer having a functionalized silane comprises one of N-methyl-N-(-triethoxypropyl)-2-[α-heptafluoropropoxty{Poly(oxy(trifluoromethyl)-1,2-ethanediyl)} tetrafluoropropionamide, Optool DSX^{™}, and a compound having the general formula
**CF3-[CH(CF**_{**3**}**)-CH**_{**2**}**-O-]**_{**x**}**-CONCH**_{**3**}**-(CH**_{**2**}**)**_{**3**}**-Si-(OC**_{**2**}**H**_{**5**}**)**_{**3**}
where x = 7-11.

3. A method according to claim 2, wherein the fluorinated alkyl ether polymer has the formula
**CF**_{**3**}**-[CH(CF**_{**3**}**)-CH**_{**2**}**-O-]**_{**x**} **-CONCH**_{**3**}**-(CH**_{**2**}**)**_{**3**}**-Si-(OC**_{**2**}**H**_{**5**}**)**_{**3**}
where x = 7-11.

4. A method according to any of claims 1 to 3, wherein the non-oxide surface comprises one of a metal halide, a metal sulfide, a metal selenide, a metal telluride, a nitride, a boride, and a semiconductor.

5. A method according to any of claims 1 to 3, wherein the non-oxide surface comprises one of an aluminate, a phosphate, a borate, a niobate, an arsenate, a titanate, and a carbonate.

6. A method according to any of claims 1 to 3, wherein the non-oxide surface comprises one of MgF₂, YF₃, LiF, CaF₂, LiYF₄, ZnS, CdS, ZnCr₂S₄, PbS, ZnSe, ZnTe, Si₃N₄, CB, GaAs, GaP, InP, InSb, YAlO₃, NH₄H₂PO₄, KTiOPO₄, LiB₃O₄, CsB₂O₃, LiNbO₃, KTiOAsO₄, BaTiO₃, and CaCO₃.

7. A method according to any of claims 1 to 3, wherein the non-oxide surface is formed of a compound selected from the group consisting of MgF₂, Si₃N₄, and YF₃_

8. A method according to any of claims 1 to 3, wherein the non-oxide surface comprises a layer having pores sufficiently large to accommodate water molecules and at least an anchoring portion of the functionalized silane.

9. A method according to any of claims 1 to 3, wherein the non-oxide surface comprises a layer applied using a vacuum vapour coating technique.

10. A method according to claim 9, wherein the non-oxide surface is a MgF₂ layer.

11. A method according to any of claims 1 to 3, wherein the non-oxide surface is an outer layer of an anti-reflection coating.

12. An anti-moisture and soil-repellent coating comprising:
a first layer comprising a non-oxide material; and
a second layer of material formed directly on the first layer, the second layer comprising a fluorinated alkyl ether polymer having a functionalized silane,
wherein the second layer is coupled to the first layer so as to form a durable coating.

13. An anti-moisture and soil-repellent coating according to claim 12, wherein the fluorinated alkyl ether polymer having a functionalized silane comprises one of N-methyl-N-(-triethoxypropyl)-2-[α-heptafluoropropoxty{Poly(oxy(trifluoromethyl)-1,2-ethanediyl)} tetrafluoropropionamide, Optool DSX^{™}, and a compound having the general formula
**CF3-[CH(CF**_{**3**}**)-CH**_{**2**}**-O-]**_{**x**}**-CONCH**_{**3**}**-(CH**_{**2**}**)**_{**3**}**-Si-(OC**_{**2**}**H**_{**5**}**)**_{**3**}
where x = 7-11.

14. An anti-moisture and soil-repellent coating according to claim 12 or 13, wherein the non-oxide material comprises one of a metal halide, a metal sulfide, a metal selenide, a metal telluride, an inorganic nitride, a boride, a semiconductor, an aluminate, a phosphate, a borate, a niobate, an arsenate, a titanate, and a carbonate.

15. An anti-moisture and soil-repellent coating according to claim 12 or 13, wherein the non-oxide material is a compound selected from the group consisting of metal halide, metal sulfide, metal selenide, metal telluride, inorganic nitride, boride, semiconductor, aluminate, phosphate, borate, niobate, arsenate, titanate, and carbonate.
